# FASCICULE DE BREVET EUROPEEN

(11) **EP 1 008 169 B1**
(45) Date de publication et mention de la délivrance du brevet: **14.01.2009**
(21) Numéro de dépôt: 98939717.9
(22) Date de dépôt: 20.07.1998
(51) Int. Cl.: H01L 21/18

(54) **REALISATION DE MICROSTRUCTURES OU DE NANOSTRUCTURES SUR UN SUPPORT**
HERSTELLUNG VON MIKRO- ODER NANOSTRUKTUREN AUF EINEM TRÄGER
PRODUCING MICROSTRUCTURES OR NANOSTRUCTURES ON A SUPPORT

(30) Priorité: 22.07.1997 FR 9709264
(43) Date de publication de la demande: 14.06.2000
(73) Titulaire: COMMISSARIAT A L'ENERGIE ATOMIQUE, 75015 Paris (FR)
(72) Inventeur: BRUEL, Michel, F-38113 Veurey (FR)
(74) Mandataire: Weber, Etienne Nicolas
(86) Numéro de dépôt international: PCT/FR1998/001585
(87) Numéro de publication internationale: WO 1999/005711

(56) Documents cités:
- FR-A- 2 681 472
- BENAMARA M ET AL: "STRUCTURAL AND ELECTRICAL INVESTIGATIONS OF SILICON WAFER BONDING INTERFACES" MATERIALS SCIENCE AND ENGINEERING B, vol. 42, no. 1 - 03, 1996, pages 164-167, XP002059412
- ABE T ET AL: "DISLOCATION-FREE SILICON ON SAPPHIRE BY WAFER BONDING" JAPANESE JOURNAL OF APPLIED PHYSICS, vol. 33, 1994, pages 514-518, XP000749264
- YANG W -S ET AL: "GOLD GETTERING IN DIRECTLY BONDED SILICON WAFERS" JAPANESE JOURNAL OF APPLIED PHYSICS, vol. 28, no. 5, PART 2, mai 1989, pages L721-L724, XP000030438
- KISH F A ET AL: "LOW-RESISTANCE OHMIC CONDUCTION ACROSS COMPOUND SEMICONDUCTOR WAFER-BONDED INTERFACES" APPLIED PHYSICS LETTERS, vol. 67, no. 14, 2 octobre 1995, pages 2060-2062, XP000195521

## Description

### Domaine technique

La présente invention concerne la réalisation de microstructures ou de nanostructures sur un support.

Les microstructures, et les nanostructures pour des dimensions encore inférieures, se présentent sous la forme d'un réseau de microvolumes de matériau obtenus à la surface d'un support. Par microvolume, on entend par exemple des volumes de forme parallélépipédique, de dimensions préférentiellement inférieures au micromètre.

Généralement, on s'intéresse à des microstructures en matériau semiconducteur et en particulier en silicium, en AsGa, en composés III-V et en SiC. Cependant, on s'intéresse également aux matériaux conducteurs, tels que les métaux, et aux matériaux diélectriques tels que SiO₂.

Ces micro- ou nanostructures sont destinées à la réalisation de dispositifs électroniques, optiques ou optoélectroniques. En particulier, ce type de structures permet la réalisation d'un réseau de boîtes quantiques (appelées "quantum dots" dans la terminologie anglo-saxonne), ou de dispositifs électroniques dits mono-électrons ou à blocage de Coulomb ("Coulomb blockade") ou encore de dispositifs émetteurs de lumière.

### Etat de la technique antérieure

Lorsque l'on veut réaliser des microstructures, on utilise les techniques aujourd'hui classiques du domaine de la micro-électronique. En particulier, on utilise les principes de la lithographie combinée avec des opérations de gravure sèche ou humide, d'implantation ionique, de dépôts et de traitement thermique. Par exemple, si l'on veut réaliser un réseau carré de microvolumes parallélépipédiques en silicium monocristallin, chaque microvolume ayant 1 µm de côté pour 0,2 µm d'épaisseur, les microvolumes étant espacés les uns des autres de 0,5 µm, on peut partir d'une plaquette SSI (Silicium Sur Isolant) présentant une couche de silicium monocristallin de 0,2 µm d'épaisseur. On applique sur la couche de silicium de la plaquette une couche de résine photosensible que l'on insole grâce à une machine d'insolation à faisceau d'électrons ("Electron Beam Pattern Generator") de façon à inscrire dans la résine une matrice de lignes et de colonnes de largeur 0,5 µm représentant les espaces entre les microvolumes. Le développement de la résine dégage les parties exposées, mettant à nu la couche de silicium correspondant à la matrice de lignes et de colonnes. La plaquette est alors soumise à un traitement de gravure plasma attaquant sélectivement le silicium par rapport à la résine. Le procédé de gravure se termine quand la couche de silice sous-jacente est atteinte. Après enlèvement de la résine, on obtient un réseau de microvolumes ayant chacun 1 µm × 1 µm × 0,2 µm de dimensions et espacées de 0,5 µm. Si nécessaire, les espaces entre microvolumes peuvent être ensuite comblés par une couche diélectrique telle que SiO₂, soit en utilisant un procédé d'oxydation thermique, soit un dépôt du type CVD.

La réalisation d'un réseau de microvolumes peut aussi être obtenue en utilisant un procédé de lithographie par interférométrie ou holographie comme le divulgue l'article "Scalable Fabrication and Optical Characterization of nm Si Structures" par S.H. ZAIDI et al., paru dans Mat. Res. Soc. Symp. Proc. Vol. 358, pages 957-968, Materials Research Society.

L'utilisation de ces techniques permet la réalisation de microstructures pour des dimensions de l'ordre du micromètre ou de quelques dixièmes de micromètre. Pour obtenir les meilleures résolutions en terme de lithographie, on utilise l'insolation par faisceau d'électrons ou un photorépéteur sur tranche fonctionnant avec une longueur d'onde de 248 nm ou 193 nm.

Pour réaliser des microstructures avec des microvolumes de dimensions bien inférieures (par exemple quelques dizaines de nanomètres), il n'existe pas de moyens connus dès lors que l'on souhaite obtenir, de façon économiquement acceptable et sur de grandes surfaces, des microstructures organisées selon un plan d'organisation prédéterminé.

On peut noter cependant que l'on peut réaliser des microvolumes d'un premier matériau à l'intérieur d'une matrice d'un deuxième matériau, par exemple en introduisant dans cette matrice, par implantation ionique, des atomes du premier matériau en une concentration telle et avec un traitement thermique tel que ces atomes se rassemblent en précipités à l'intérieur de la matrice. On peut ainsi obtenir des précipités de silicium dans une matrice de SiO₂ de l'ordre de 10 nm. Une telle technique est décrite par exemple dans l'article "Control of and Mechanisms for Room Temperature Visible Light Emission from Silicon Nanostructures in SiO2 Formed by Si+ Ion Implantation" de T. KOMODA et al., paru dans Mat. Res. Soc. Symp. Proc. Vol. 358, pages 163-168, 1995, Materials Research Society. Cependant, les précipités obtenus sont répartis au hasard dans la matrice.

De façon analogue, en réalisant un dépôt (par exemple, par évaporation) sur une surface, on peut obtenir des noyaux de condensation répartis au hasard sur la surface. L'article "Generation and Structural Analysis of Silicon Nanoparticles" de PING LI et K. SATTLER, paru dans Mat. Res. Soc. Symp. Proc. Vol. 358, pages 123-126, 1995, Materials Research Society, divulgue l'évaporation de silicium sur une surface de silicium ou de graphite.

Les applications de ces microstructures sont multiples et dépendent des propriétés particulières de chacune. Ces propriétés sont liées à un effet de taille sur les états électroniques des porteurs dans ces matériaux, aux effets de surface, d'interface, à l'existence ou non de phases intergranulaires, etc. Une application particulière est la réalisation d'émetteurs de lumière, notamment à partir de matériaux tels que le silicium qui, à l'état monocristallin massif ne sont pas émetteurs (voir l'article de T. KOMOKA déjà cité). Une autre application est la réalisation de dispositifs électroniques basés sur le confinement quantique des porteurs électroniques dans les microvolumes de la structure ou à des effets de blocage de Coulomb. Cette application est décrite dans l'article "Modelling the Multiplicity of Conductance Structures in Clusters of Silicon Quantum Dots" de D. W. BOERINGER et R. TSU, paru dans Mat. Res. Soc. Symp. Proc. Vol. 358, pages 569-574, 1995, Materials Research Society.

Dans l'article de M.Benamara et al, Materials Science and Engineering B42, (1996), pages 164-167, on étudie le réseau de défauts formé par le collage de 2 substrats cristallins dont les réseaux sont décalés.

### Exposé de l'invention

La présente invention a été conçue afin de permettre la réalisation de micro-structures pouvant comporter des microvolumes de dimensions nettement inférieures aux microvolumes réalisables actuellement, par exemple quelques dizaines de nm, de façon économique et sur de grandes surfaces. En outre, ces microstructures sont organisées selon un plan prédéterminé au lieu d'être réparties au hasard.

L'invention propose un procédé de réalisation, de micro- ou de nanostructures, qui s'applique à des matériaux cristallins, qu'ils soient semiconducteurs, conducteurs ou diélectriques.

L'invention a donc pour objet un procédé de réalisation de micro- ou de nanostructure sur un support, caractérisé en ce qu'il comporte les étapes suivantes :
- collage par mise en contact d'une face d'une première plaquette en matériau cristallin avec une face d'une deuxième plaquette en matériau cristallin, de façon que les réseaux cristallins présentés par lesdites faces présentent au moins un paramètre de désaccord apte à permettre la formation d'un réseau de défauts cristallins et/ou d'un réseau de contraintes au sein d'une zone cristalline s'étendant de part et d'autre de l'interface des deux plaquettes, au moins l'un desdits réseaux définissant la micro- ou la nanostructure,
- amincissement de l'une des deux plaquettes pour faire apparaître le réseau de défauts et/ou le réseau de contraintes sur un support constitué par l'autre plaquette et traitement sélectif du réseau de défauts cristallins et/ou du réseau de contraintes.

Le paramètre de désaccord peut être constitué par un angle déterminé de décalage en rotation des réseaux cristallins présentés par lesdites faces. Le réseau de défauts obtenu, dit de "twist" est un réseau de dislocations à caractère vis.

Le paramètre de désaccord peut aussi être constitué par une différence de paramètre de maille cristalline entre les matériaux cristallins des faces des plaquettes mises en contact le réseau de défauts obtenu est dit de "misfit".

Le paramètre de désaccord peut encore être constitué par un angle déterminé selon lequel la face d'au moins l'une des plaquettes est décalée par rapport au plan cristallographique simple de direction correspondant à cette face. Les faces cristallines désorientées (une seule ou les deux) par rapport à un plan cristallographique simple sont dites vicinales. Le réseau de défaut est dit de "miscut".

Toutes les combinaisons de paramètres de désaccord sont possibles, par exemple en collant deux matériaux différents et décalés en rotation. Plusieurs réseaux sont alors formés.

La mise en contact peut être préférentiellement du type hydrophobe, c'est-à-dire à collage direct des faces desdites plaquettes. Elle peut être du type hydrophile, c'est-à-dire impliquant une fine couche intermédiaire, par exemple une couche d'oxyde formée naturellement sur une face d'une plaquette ou sur les faces des plaquettes.

Avantageusement, le procédé comporte en outre au moins une étape de traitement thermique destinée soit à compléter la formation du réseau de défauts cristallins et/ou du réseau de contraintes si la mise en contact est insuffisante pour l'achever, soit à l'achever complètement. De plus, ce traitement peut être apte à renforcer les liaisons interatomiques entre les faces des plaquettes mises en contact. Ce traitement thermique peut être réalisé avant ou après l'étape d'amincissement.

L'étape d'amincissement peut être réalisée au moyen d'une technique choisie parmi la rectification, l'abrasion mécanique ou l'abrasion chimique.

L'étape d'amincissement peut aussi être réalisée par clivage de l'une des plaquettes qui, avant l'étape de mise en contact a été soumise, au travers de sa face à mettre en contact, à une étape d'implantation ionique destinée à créer, à une profondeur déterminée et correspondant à l'amincissement désirée, une couche de microcavités susceptible de générer un plan de clivage lors d'une étape postérieure de traitement thermique. L'implantation ionique peut être réalisée au moyen d'ions hydrogène. Dans le cas où l'étape d'amincissement est ainsi réalisée, il peut être prévu au moins une étape de traitement thermique permettant simultanément de compléter ou d'achever la formation du réseau de défauts cristallins et/ou du réseau de contraintes, de renforcer les liaisons interatomiques entre les faces des plaquettes mises en contact et de générer le plan de clivage.

En fonction des utilisations auxquelles la micro- ou la nanostructure est destinée, après l'étape d'amincissement, il peut être prévu une étape consistant à traiter sélectivement le réseau de défauts cristallins et/ou le réseau de contraintes par rapport à ladite zone cristalline. Ceci permet en particulier d'accentuer la différence de comportement physique/électrique ou optoélectronique des défauts cristallins par rapport à ladite zone cristalline ou, de façon plus générale, de délimiter des micro- ou nanovolumes dans ou au-dessus de la zone cristalline. Cette étape de traitement sélectif peut consister à rendre conducteurs les défauts cristallins et/ou le réseau de contraintes de manière que ladite zone cristalline forme des plots cristallins reliés électriquement entre eux. Dans ce cas, on peut procéder à une diffusion de phosphore qui diffuse préférentiellement au niveau des défauts cristallins. L'étape de traitement sélectif peut aussi consister en une isolation électrique afin que ladite zone cristalline forme des plots cristallins isolés électriquement entre eux. Dans ce cas, on peut procéder à une attaque chimique du réseau de défauts cristallins et/ou du réseau de contraintes, éventuellement suivie du dépôt d'un isolant électrique. L'attaque chimique peut être précédée d'une phase de décoration de défauts cristallins et/ou du réseau de contraintes par précipitation d'impuretés métalliques ou dopantes.

Le réseau de défauts produit par les techniques indiquées ci-dessus s'étend une faible épaisseur de part et d'autre de la surface de collage des deux plaquettes. Par contre, les contraintes induites par ces défauts s'étendent de chaque côté de l'interface, dans les plaquettes, sur des distances de l'ordre de grandeur de la période des dislocations. Ainsi, l'amincissement de l'une des plaquettes peut se faire en arrêtant l'opération à une distance de l'interface qui est du même ordre de grandeur. A la surface ainsi exposée, et avant d'être parvenu sur les défauts cristallins, le champ de contraintes en surface est non uniforme et est à l'image de réseau de défauts sous-jacent. L'étape de traitement sélectif peut alors consister à déposer, par exemple par épitaxie, un matériau cristallin désaccordé en maille cristalline avec le matériau cristallin révélé par l'étape d'amincissement, ce matériau cristallin déposé formant un ensemble ordonné d'îlots en correspondance avec le réseau de défauts cristallins sous-jacent.

L'isolation électrique du traitement sélectif peut être du type où une conduction électrique peut y avoir lieu par un effet physique tel que l'effet tunnel ou l'effet Fowler-Nordheim.

L'étape de traitement sélectif peut aussi consister à traiter les défauts cristallins et/ou le réseau de contraintes de manière que ladite zone cristalline forme des plots cristallins reliés entre eux par des zones semiconductrices ou présentant une barrière de potentiel.

L'invention a aussi pour objet une micro- ou nanostructure sur un support, caractérisée en ce qu'elle est obtenue selon le procédé décrit ci-dessus à partir de plaquettes dont les faces à mettre en contact sont en matériaux semiconducteurs. Au moins l'une de ces faces à mettre en contact peut être en SiC ou en matériau semiconducteur III-V tel que AsGa ou GaAlAs.

L'invention a encore pour objet une micro-ou nanostructure sur un support, caractérisée en ce qu'elle est obtenue selon le procédé décrit ci-dessus, l'une des plaquettes étant constituée d'une plaquette Silicium-Sur-Isolant, l'autre plaquette étant en silicium et constituant la plaquette amincie, le procédé permettant l'obtention d'une micro- ou d'une nanostructure constituée de microvolumes de silicium sur une couche d'isolant.

L'invention est telle que définie dans les revendications.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1A représente deux plaquettes de matériau cristallin lors de leur mise en contact, selon une première variante du procédé de réalisation de la présente invention,
- la figure 1B représente deux plaquettes de matériau cristallin lors de leur mise en contact, selon une seconde variante du procédé de réalisation de la présente invention,
- la figure 1C représente deux plaquettes de matériau cristallin lors de leur mise en contact, selon une troisième variante du procédé de réalisation de la présente invention,
- la figure 2 est une vue de côté d'un ensemble formé des deux plaquettes de la figure 1A après leur mise en contact,
- la figure 3 est une vue de côté de l'ensemble représenté à la figure 2, après l'étape d'amincissement du procédé selon la présente invention,
- la figure 4 est une vue de côté d'une microstructure obtenue par la présente invention,
- la figure 5 est une vue de côté d'une autre microstructure obtenue par la présente inivention.

### Description détaillée de modes de réalisation de l'invention

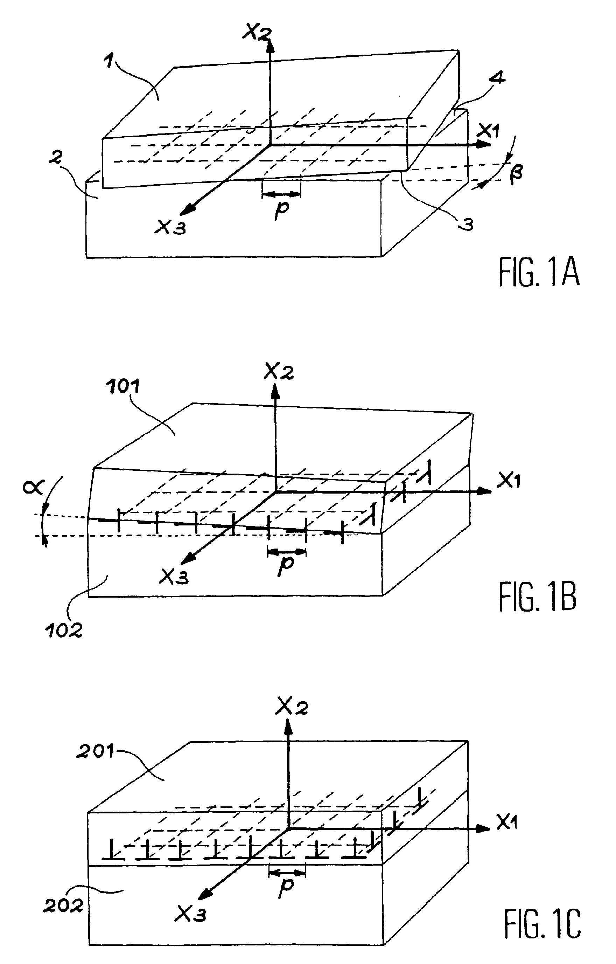

Les figures 1A, 1B et 1C illustrent trois variantes de mise en oeuvre du procédé selon la présente invention. X₁, X₂ et X₃ représentent les axes cristallographiques. Dans le cas de la figure 1A, le paramètre qui règle la densité de défauts (ou la distance moyenne entre défauts) est l'angle de rotation β existant entre les réseaux cristallins présentés par les faces mises en contact des plaquettes 1 et 2. Dans le cas de la figure 1B, le paramètre qui règle la densité de défauts (ou la distance moyenne entre défauts) est l'angle de rotation α existant entre les plans cristallographiques des plaquettes 101 et 102 mises sen contact. Dans le cas de la figure 1C, le paramètre qui règle la densité de défauts (ou la distance moyenne entre défauts) est le désaccord de maille f₁ entre les deux matériaux cristallins des plaquettes 201 et 202 mises en contact.

Le tableau ci-dessous donne les valeurs de l'angle de rotation β, de l'angle de désorientation α et du désaccord de maille f₁ en fonction de la période p du réseau de défauts à l'interface (cas du silicium 100).

| | | | | | |
|---|---|---|---|---|---|
| Période (nm) | 76 | 38,4 | 19,2 | 9,6 | 3,8 |
| α ((°) | 0,2 | 0,4 | 0,8 | 1,6 | 4 |
| β(°) | 0,29 | 0,6 | 1,2 | 2,4 | 6 |
| f₁ (%) | 0,5 | 1 | 2 | 4 | 10 |

A titre d'exemple, pour la variante du procédé illustré par la figure 1A, deux plaquettes de silicium (100) collées avec une rotation β de 1,2° forment à leur interface un réseau de dislocations vis carré de période 19,2 nm. Après amincissement de l'une des plaquettes jusqu'à p/2 = 9,6 nm et après révélation par l'une des techniques décrites, on obtient une densité de nanostructures de 2,7.10¹⁵/m² et ayant une taille inférieure à 9,6 nm.

Pour obtenir une période de 19,2 nm avec la variante du procédé illustrée par la figure 1B, on peut préparer l'une des plaquettes avec une face vicinale décalée dans la direction <100> de 0,8° et collée sur une plaquette de silicium (100) non vicinale. Les densités de nanostructures obtenues sont alors de 2,7.10¹⁵/m².

Pour la variante du procédé illustrée par la figure 1C, une plaquette de silicium (100) est collée à une deuxième plaquette comportant en surface une couche de SiGe. Le désaccord f₁ étant de 2,1% il se forme un réseau d'interface de dislocation coin de période 20 nm. Après amincissement de la plaquette comportant la couche de SiGe jusqu'à environ 10 nm, et après révélation par l'une des techniques décrites, on obtient une densité de nanostructures du même ordre de grandeur que précédemment. Le collage d'une plaquette de germanium produirait un désaccord double et donc une densité de nanostructures quatre fois plus élevé.

Des faces autres que des faces (100) peuvent être utilisées. Par exemple les faces (111) produisent à leur interface des réseaux hexagonaux ou triangulaires de dislocations. Des faces (110) produisent des réseaux rectangulaires. Deux faces d'orientations différentes, collées l'une sur l'autre, produisent également des réseaux périodiques ou quasi-périodiques.

La variante du procédé illustré par la figure 1A va maintenant être décrite plus en détail.

Pour simplifier la description, on considère un réseau de défauts cristallins étant bien entendu qu'il est généralement associé à un réseau de contraintes et que des traitements sélectifs peuvent être également faits sur le réseau de contraintes.

La figure 1A montre deux plaquettes 1 et 2 en silicium de plan cristallographique (1,0,0) lors de leur mise en contact et présentant des faces planes, respectivement 3 et 4, en regard. Les faces planes 3 et 4 ont reçu un traitement de surface pour les rendre hydrophobes. Ceci assurera une mise en contact intime et adhérent des faces 3 et 4. Ce traitement de surface comprend une étape de nettoyage chimique se terminant par exemple par une étape d'attaque à l'acide fluorhydrique. Pour plus de détails, on pourra se reporter au chapitre "Silicon Surface Chemical Composition and Morphology" par Gregg S. HIGASHI et Yves J. CHABAL, pages 433 et suivantes de l'ouvrage "Handbook of Semiconductor Wafer Cleaning Technology", publié sous la direction de Werner KERN chez Noyes Publications, Park Ridge, New Jersey, USA.

On effectue une mise en contact des faces 3 et 4 avec collage par adhésion moléculaire, par exemple à température ambiante, en veillant que les réseaux cristallins présentés par les deux faces soient décalés l'un par rapport à l'autre d'un angle β déterminé, par exemple 0,6°.

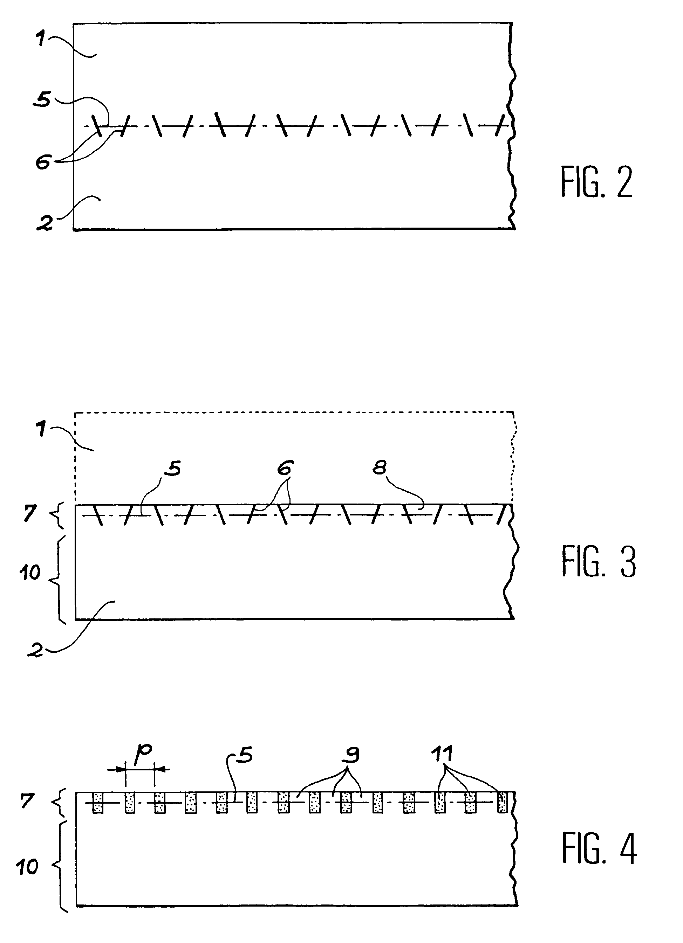

L'ensemble constitué par ces deux plaquettes solidarisées est alors soumis à un traitement thermique à une température de l'ordre de 950°C pendant environ 30 minutes. Lors de ce traitement thermique, des liaisons interatomiques plus fortes et plus nombreuses s'établissent entre les deux plaquettes. En raison de l'angle de torsion existant entre les deux réseaux cristallins, un réseau de défauts cristallins, par exemple un réseau de dislocations, s'établit au voisinage de l'interface entre les deux plaquettes, dans une couche de faible épaisseur (quelques dizaines à quelques centaines de nm) centrée sur l'interface. Ceci est représenté schématiquement sur la figure 2 où la référence 5 désigne cette interface, les défauts cristallins (ou dislocations) étant figurés sous la référence 6.

L'expérience montre que ces dislocations forment un réseau régulier bidimensionnel (carré dans l'exemple donné ici) de pas d'environ 40 nm. Ces faits sont expliqués de manière théorique dans l'article "TEM Observations on Grain Boundaries in Sintered Silicon" de H. FOLL et D. AST, paru dans la revue Philosophical Magazine A, 1979, vol. 40, N° 5, pages 589-610. La page 596 de cet article reproduit une photographie d'un tel réseau de dislocations.

L'espacement entre deux dislocations adjacentes est fonction de l'angle β de rotation des réseaux cristallins des deux plaquettes. La valeur de cet espacement varie comme l'inverse de sin(β/2). Pour β= 5°, on obtient un espacement entre dislocations adjacentes de 4,4 nm.

Pour obtenir une microstructure à partir de l'ensemble représenté à la figure 2, il suffit alors d'abraser (par rectification, abrasion mécanique ou chimique) l'une des deux plaquettes en arrêtant l'opération d'abrasion lorsque la zone de dislocations est atteinte. C'est ce que montre la figure 3 où la microstructure est désignée sous la référence 7. Elle repose sur un support 10 constitué par la plus grande partie de la plaquette 2.

Un traitement de surface peut ensuite être mis en oeuvre pour différencier, de manière plus spécifique, les défauts cristallins de la zone cristalline 8 environnante.

On peut, par exemple, au moyen d'un bain chimique attaquer sélectivement les défauts cristallins 6 sans attaquer la zone cristalline 8 adjacente. Dans l'exemple de réalisation donné ici, on peut utiliser les bains chimiques SECCO^{®} ou WRIGHT^{®}. On obtient alors un réseau de microvolumes de silicium de forme carrée, suivant un réseau au pas p de 40 nm, isolés les uns des autres par des espacements.

Une isolation diélectrique latérale des microvolumes 9 peut être effectuée. Pour cela on peut, par exemple, oxyder thermiquement la microstructure 7
ou effectuer un dépôt CVD. Pour certaines applications, la couche d'oxyde déposée sur la microstructure 7 peut être arasée, comme cela est représenté sur la figure 4, pour ne garder qu'un dépôt d'isolant 11 entre les microvolumes 9. Dans ce cas, on obtient un réseau de matériau isolant se substituant au réseau de dislocations.

Le traitement de surface peut aussi être mené pour rendre le réseau de dislocations conducteur, isolant, voire semiconducteur en fonction de l'application visée. Ceci permet de rendre les microvolumes ou plots cristallins, soit reliés électriquement entre eux par des liaisons conductrices, soit isolés électriquement, soit reliés par des zones semi-conductrices ou présentant une barrière de potentiel. Concernant l'isolation électrique, on comprend aussi des isolations telles que la conduction électrique à travers les parties isolantes peut avoir lieu par effet tunnel par exemple, ou par effet Fowler-Nordheim ou par tout autre effet physique. Pour rendre conducteur le réseau de dislocations, on peut réaliser une diffusion de phosphore qui diffuse préférentiellement au niveau des dislocations.

Une autre possibilité de réaliser l'étape d'amincissement consiste à appliquer le procédé décrit dans le document FR-A-2 681 472 de manière à obtenir un clivage de la plaquette concernée. Pour cela, on implante par exemple des protons dans cette plaquette pour obtenir une couche de microcavités à la profondeur voulue de la face à mettre en contact. Cette face subit le traitement de nettoyage et de collage. Le traitement thermique est ensuite appliqué. Il permet de générer simultanément la création de dislocations et le clivage selon la couche de microcavités.

L'une des plaquettes, celle destinée à constituer le support, peut être une plaquette SSI (Silicium-Sur-Isolant) appelée SOI ("Silicon on Insulator") dans la terminologie anglo-saxonne et l'autre plaquette peut être un substrat massif de silicium. Le procédé selon l'invention procure alors un réseau de microvolumes de silicium sur une couche d'isolant.

Les deux plaquettes de matériau cristallin peuvent être de nature différente, par exemple une plaquette de silicium et une plaquette d'arséniure de gallium, ou une plaquette de silicium et une plaquette de germanium. Par ailleurs, les plaquettes ne sont pas forcément homogènes. Il suffit simplement que les faces à mettre en contact soient en matériau cristallin, le reste des plaquettes pouvant présenter d'autres structures.

Comme il a été dit plus haut, la micro- ou la nanostructure peut encore être obtenue à partir d'un réseau de contraintes. Ce réseau de contraintes peut être révélé par diverses techniques.

Le réseau de contraintes peut être révélé par dépôt, par un procédé d'épitaxie (MOCVD, MBE, épitaxie en phase liquide...), sur la plaquette amincie d'un matériau cristallin désaccordé en maille cristalline. Dans le mode de croissance en îlots, les sites de nucléation préférentiels fournis par les zones en compression (respectivement en tension) seront favorables pour les dépôts à mailles plus petites (respectivement plus grandes) que la plaquette amincie. Il sera ainsi formé un ensemble ordonné d'îlots de taille correspondant au réseau sous-jacent.

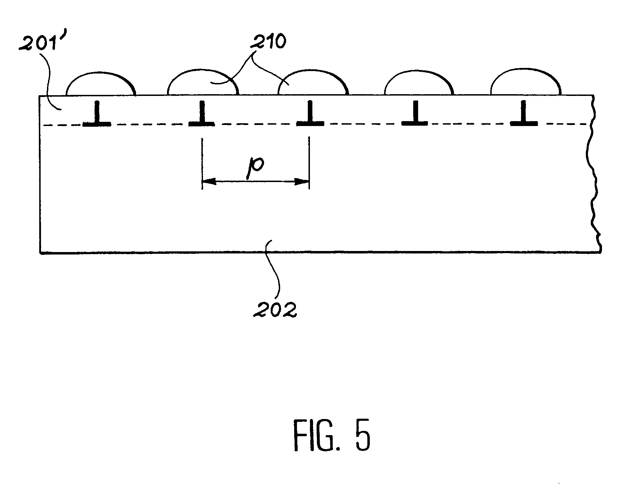

Ce dépôt peut être illustré à partir de la variante du procédé illustrée par la figure 1C. Un ensemble a été préparé selon cette variante, comme décrit plus haut, à partir d'une plaquette de silicium d'orientation (100) et une plaquette comportant la couche de SiGe. Après amincissement, on obtient l'ensemble représenté à la figure 5 où la référence 202 désigne la plaquette de silicium et la référence 201' ce qui reste de la couche de SiGe. Un dépôt de germanium pur est effectué en conditions de croissance de Stranski-Krastanov. Des îlots de germanium nanométriques 210 sont nucléés à l'aplomb des noeuds du réseau de dislocations, dans les zones de contraintes en tension.

## Revendications

1. Procédé de réalisation de micro- ou de nanostructure sur un support, **caractérisé en ce qu'**il comporte les étapes suivantes :
- collage par mise en contact d'une face (3) d'une première plaquette (1) en matériau cristallin avec une face (4) d'une deuxième plaquette (2) en matériau cristallin, de façon que les réseaux cristallins présentés par lesdites faces présentent au moins un paramètre de désaccord apte à permettre la formation d'un réseau de défauts cristallins (6) et/ou d'un réseau de contraintes au sein d'une zone cristalline (8) s'étendant de part et d'autre de l'interface des deux plaquettes, au moins l'un desdits réseaux définissant la micro- ou la nanostructure,
- amincissement de l'une des deux plaquettes pour faire apparaître le réseau de défauts et/ou le réseau de contraintes sur un support (10) constitué par l'autre plaquette,
- traitement sélectif du réseau de défauts cristallins (6) et/ou du réseau de contraintes par rapport à ladite zone cristalline (8) .

2. Procédé selon la revendication 1, **caractérisé en ce que** ledit paramètre de désaccord est constitué par un angle (θ) déterminé de décalage en rotation des réseaux cristallins présentés par lesdites faces.

3. Procédé selon la revendication 1, **caractérisé en ce que** ledit paramètre de désaccord est constitué par une différence de paramètre de maille cristalline entre les matériaux cristallins des faces des plaquettes mises en contact.

4. Procédé selon la revendication 1, **caractérisé en ce que** ledit paramètre de désaccord est constitué par un angle (α) déterminé selon lequel la face d'au moins l'une des plaquettes est décalée par rapport au plan cristallographique simple de direction correspondant à cette face.

5. Procédé selon l'une quelconque des revendications 1 à 4, **caractérisé en ce que** la mise en contact est du type hydrophobe.

6. Procédé selon l'une quelconque des revendications 1 à 4, **caractérisé en ce que** la mise en contact est du type hydrophile.

7. Procédé selon l'une quelconque des revendications 1 à 6, **caractérisé en ce que**, lors de l'étape de mise en contact, on soumet la première et la deuxième plaquette à au moins l'une des opérations suivantes : traitement thermique, mise en pression, application d'un champ électrique.

8. Procédé selon l'une quelconque des revendications 1 à 7, **caractérisé en ce qu'**il comporte en outre au moins une étape de traitement thermique destinée à compléter ou achever la formation du réseau de défauts cristallins et/ou du réseau de contraintes.

9. Procédé selon l'une quelconque des revendications 1 à 8, **caractérisé en ce que** l'étape d'amincissement est réalisée au moyen d'une technique choisie parmi la rectification, l'abrasion mécanique ou l'abrasion chimique.

10. Procédé selon l'une quelconque des revendications 1 à 8, **caractérisé en ce que** l'étape d'amincissement est réalisée par clivage de l'une des plaquettes qui, avant l'étape de mise en contact a été soumise, au travers de sa face à mettre en contact, à une étape d'implantation ionique destinée à créer, à une profondeur déterminée et correspondant à l'amincissement désirée, une couche de microcavités susceptible de générer un plan de clivage lors d'une étape postérieure de traitement thermique.

11. Procédé selon la revendication 10, **caractérisé en ce que** l'implantation ionique est réalisée au moyen d'ions hydrogène.

12. Procédé selon l'une des revendications 10 ou 11 lorsqu'elles sont rattachées à la revendication 7, **caractérisé en ce qu'**il est prévu au moins une étape de traitement thermique permettant simultanément de compléter ou d'achever la formation du réseau de défauts cristallins et/ou du réseau de contraintes et de générer le plan de clivage.

13. Procédé selon l'une quelconque des revendications 1 à 12, **caractérisé en ce que** l'étape de traitement sélectif consiste à rendre conducteurs les défauts cristallins (6) et/ou le réseau de contraintes de manière que ladite zone cristalline (8) forme des plots cristallins reliés électriquement entre eux.

14. Procédé selon la revendication 13, **caractérisé en ce que** les défauts cristallins (6) sont rendus conducteurs par diffusion de phosphore.

15. Procédé selon l'une quelconque des revendications 1 à 12, **caractérisé en ce que** l'étape de traitement sélectif consiste en une isolation électrique (11) afin que ladite zone cristalline forme des plots cristallins (9) isolés électriquement entre eux.

16. Procédé selon la revendication 15, **caractérisé en ce que** le traitement sélectif consiste en une attaque chimique des défauts cristallins et/ou du réseau de contraintes.

17. Procédé selon la revendication 16, **caractérisé en ce que** ladite attaque chimique est précédée d'une phase de décoration des défauts cristallins et/ou du réseau de contraintes par précipitation d'impuretés métalliques ou dopantes.

18. Procédé selon la revendication 16, **caractérisé en ce que** l'attaque chimique est suivie du dépôt d'un isolant électrique.

19. Procédé selon la revendication 15, **caractérisé en ce que** ladite isolation électrique est du type où une conduction électrique peut y avoir lieu par un effet physique tel que l'effet tunnel ou l'effet Fowler-Nordheim.

20. Procédé selon l'une quelconque des revendications 1 à 12, **caractérisé en ce que** l'étape de traitement sélectif consiste à traiter les défauts cristallins et/ou le réseau de contraintes de manière que ladite zone cristalline forme des plots cristallins reliés entre eux par des zones semiconductrices ou présentant une barrière de potentiel.

21. Procédé selon l'une quelconque des revendications 1 à 12, **caractérisé en ce que** l'étape de traitement sélectif consiste à déposer, par épitaxie, un matériaux cristallin désaccordé en maille cristalline avec le matériau cristallin révélé par l'étape d'amincissemenmt, ce matériau cristallin déposé formant un ensemble ordonné d'îlots en correspondance avec le réseau de défauts cristallins et/ou le réseau de contraintes sous-jacent.

22. Micro- ou nanostructure sur un support, **caractérisée en ce qu'**elle est obtenue selon l'une quelconque des revendications 1 à 21 à partir de plaquettes (1,2) dont l'une a été amincie, ces plaques ayant des faces en contact (3,4) en matériaux semiconducteurs, les réseaux cristallins présentés par lesdites faces présentant au moins un paramètre de désaccord , la plaque amincie présentant en surface un réseau de défauts cristallins et/ou d'un réseau de contraintes d'où résulte ladite micro- ou nanostructure

23. Micro- ou nanostructure sur un support selon la revendication 22, **caractérisé en ce qu'**au moins l'une desdites faces à mettre en contact est en SiC.

24. Micro- ou nanostructure sur un support selon la revendication 21, **caractérisé en ce qu'**au moins l'une desdites faces à mettre en contact est en matériau semiconducteur III-V tel que AsGa ou GaAlAs.

25. Micro- ou nanostructure sur un support, **caractérisée en ce qu'**elle est obtenue selon l'une quelconque des revendications 1 à 21, l'une des plaquettes étant constituée d'une plaquette Silicium-Sur-Isolant, l'autre plaquette étant en silicium et constituant la plaquette amincie, le procédé permettant l'obtention d'une micro- ou d'une nanostructure constituée de microvolumes de silicium sur une couche d'isolant.

## Claims

1. Method for producing a micro or nanostructure on a substrate, **characterized in that** it comprises the following steps :
- bonding by placing one surface (3) of a first wafer (1) in crystalline material in contact with one surface (4) of a second wafer (2) in crystalline material, such that the crystalline lattices presented by said surfaces offer at least one mismatch parameter able to allow the formation of a lattice of crystalline defects (6) and/or a lattice of strains within a crystalline zone (8) extending either side of the interface of the two wafers, at least one of said lattices determining the micro or nanostructure,
- thinning one of the two wafers to expose the lattice defects and/or lattice strains on a substrate (10) formed by the other wafer,
- selective treatment of the lattice crystalline defects (6) and/or lattice strains in relation to said crystalline zone (8).

2. Method according to claim 1, **characterized in that** said mismatch parameter is formed by a determined angle of rotational shift (θ) in the crystalline lattices presented by said surfaces.

3. Method according to claim 1, **characterized in that** said mismatch parameter is formed by a difference in crystalline mesh parameter between the crystalline materials of the contacted surfaces of the wafers.

4. Method according to claim 1, **characterized in that** said mismatch parameter is formed by a determined angle (α) according to which the surface of at least one of the wafers is shifted in relation to the ordinary crystallographic plane direction corresponding to this surface.

5. Method according to any one of claims 1 to 4, **characterized in that** the contacting is of hydrophobic type.

6. Method according to any one of claims 1 to 4, **characterized in that** the contacting is of hydrophilic type.

7. Method according to any one of claims 1 to 6, **characterized in that**, during the contacting step, the first wafer and second wafer are submitted to at least one of the following operations : heat treatment, pressurizing, application of an electric field.

8. Method according to any one of claims 1 to 7, **characterized in that** it also comprises at least one heat treatment step intended to complete or end the formation of the lattice of crystalline defects and/or lattice strains.

9. Method according to any one of claims 1 to 8, **characterized in that** the thinning step is conducted by means of a technique chosen from among grinding, mechanical polishing or chemical polishing.

10. Method according to any one of claims 1 to 8, **characterized in that** the thinning step is conducted by cleavage of one of the wafers which, before the contacting step, is subjected via its contacting surface to an ion implantation step intended, at a determined depth corresponding to the required thinning, to create a layer of microcavities able to generate a cleavage plane during a subsequent heat treatment step.

11. Method according to claim 10, **characterized in that** ion implantation is made by means of hydrogen ions.

12. Method according to either of claims 10 or 11, when dependent on claim 7, **characterized in that** at least one heat treatment step is planned making it possible simultaneously to complete or end the formation of a lattice of crystalline defects and/or lattice of strains and to generate the cleavage plane.

13. Method according to any of claims 1 to 12, **characterized in that** the selective treatment step consists of making conductive the crystalline defects (6) and/or the lattice strains such that said crystalline zone (8) forms crystalline pads electrically connected to one another.

14. Method according to claim 13, **characterized in that** the crystalline defects (6) are made conductive by phosphorus diffusion.

15. Method according to any of claims 1 to 12, **characterized in that** the selective treatment step consists of electric insulation (11) so that said crystalline zone forms crystalline pads (9) electrically insulated from one another.

16. Method according to claim 15, **characterized in that** the selective treatment consists of chemically etching the crystalline defects and/or lattice strains.

17. Method according to claim 16, **characterized in that** said chemical etching is preceded by a decoration phase of the crystalline defects and/or lattice strains by precipitation of metallic or doping impurities.

18. Method according to claim 16, **characterized in that** chemical etching is followed by the depositing of an electric insulator.

19. Method according to claim 15, **characterized in that** said electric insulation is of the type in which electric conduction may take place therein by means of a physical effect such as the tunnelling effect or the Fowler-Nordheim effect.

20. Method according to any of claims 1 to 12, **characterized in that** the selective treatment step consists of treating the crystalline defects and/or lattice strains such that said crystalline zone forms crystalline pads connected together by semiconductor zones or having a potential barrier.

21. Method according to any of claims 1 to 12, **characterized in that** the selective treatment step consists of depositing, by epitaxy, a crystalline material having crystalline mesh mismatch with the crystalline material exposed by the thinning step, this deposited crystalline material forming an arranged set of islands corresponding to the lattice of crystalline defects and/or underlying lattice strains.

22. Micro or nanostructure on a substrate, **characterized in that** it is obtained according to any one of claims 1 to 21 from wafers (1,2), one of which has been thinned, these wafers having contacting surfaces(3,4) in semiconductor material, the crystalline lattices presented by said surfaces offering at least one mismatch parameter, the thinned wafer presenting on its surface a lattice of crystalline defects and/or lattice of strains from which arises said micro- or nanostructure.

23. Micro or nanostructure on a substrate according to claim 22, **characterized in that** at least one of said contacting surfaces is in SiC.

24. Micro or nanostructure on a substrate according to claim 21, **characterized in that** at least one of said contacting surfaces is in III-V semiconductor material such as AsGa or GaAlAs.

25. Micro or nanostructure on a substrate, **characterized in that** it is obtained according to any one of claims 1 to 21, one of the wafers being formed by a Silicon-On-Insulator wafer, the other wafer being in silicon and forming the thinned wafer, the method enabling a micro or nanostructure to be obtained made up of silicon microvolumes on an insulator layer.

## Patentansprüche

1. Verfahren zur Herstellung einer Mikro- oder Nanostruktur auf einem Träger, **dadurch gekennzeichnet, dass** es die folgenden Schritte umfasst:
- Verklebung einer Fläche (3) eines ersten Plättchens (1) aus kristallinem Material mit einer Fläche (4) eines zweiten Plättchen (2) aus kristallinem Material durch Kontaktherstellung, derart dass die Kristallgitter, welche die genannten Flächen aufweisen, wenigstens einen Diskrepanzparameter aufweisen, fähig zur Bildung eines Kristalldefskte-Gitters (6) und/oder eines Spannungen-Gitters im Innern einer sich beiderseits der Trennebene der beiden Plättchen erstreckenden kristallinen Zone (8), wobei wenigstens eines der genannten Gitter die Mikro- oder Nanostruktur definiert,
- Dünnung von einem der beiden Plättchen, um das Fehlergitter und/oder das Spannungen-Gitter auf einem Träger (10) erscheinen zu lassen, gebildet durch das andere Plättchen,
- Selektivbehandelung des Kristalldefekte-Gitters (6) und/oder des Spannungen-Gitters in Bezug auf die genannte kristalline Zone (8).

2. Verfahren nach Anspruch 1, **dadurch gekennzeichnet, dass** der genannte Diskrepanzparameter gebildet wird durch einen bestimmten durch die Kristallgitter der genannten Flächen gebildeten Rotationsverschiebungswinkel (θ).

3. Verfahren nach Anspruch 1, **dadurch gekennzeichnet, dass** der genannte Diskrepanzparameter durch eine Kristallmaschen-Parameterdiffenenz zwischen den kristallinen Materialien der in Kontakt gebrachten Flächen der Plättchen gebildet wird.

4. Verfahren nach Anspruch 1, **dadurch gekennzeichnet, dass** der genannte Diskrepanzparameter durch einen bestimmten Winkel (α) gebildet wird, gemäß dem die Fläche von wenigstens einem der Plättchen in Bezug auf die einfache kristallographische Ebene der dieser Fläche entsprechenden Richtung verschoben ist.

5. Verfahren nach einem der Ansprüche 1 bis 4, **dadurch gekennzeichnet, dass** die Kontaktherstellung hydrophober Art ist.

6. Verfahren nach einem der Ansprüche 1 bis 4, **dadurch gekennzeichnet, dass** die Kontaktherstellung hydrophiler Art ist.

7. Verfahren nach einem der Ansprüche 1 bis 6, **dadurch gekennzeichnet, dass** man während des Kontaktherstellungsschritts das erste und das zweite Plättchen wenigstens einer der folgenden Operationen aussetzt: Wärmebehandlung, Unterdrucksetzung, Anwendung eines elektrischen Feldes.

8. Verfahren nach einem der Ansprüche 1 bis 7, **dadurch gekennzeichnet, dass** es außerdem wenigstens einen Wärmebehandlungsschritt umfasst, dazu bestimmt, die Bildung des Kristalldefekte-Gitters und/oder Spannungen-Gitters zu komplettieren oder zu beenden.

9. Verfahren nach einem der Ansprüche 1 bis 8, **dadurch gekennzeichnet, dass** der Dünnungsschritt mit Hilfe einer unter Schleifen, mechanischer Abrasion oder chemischer Abrasion ausgewählten Technik realisiert wird.

10. Verfahren nach einem der Ansprüche 1 bis 8, **dadurch gekennzeichnet, dass** der Dünnungsschritt durch Spaltung eines der Plättchen realisiert wird, das vor dem Kontaktherstellungsschritt - durch seine Kontaktherstellungsfläche hindurch - einem Ionenimplantationsschritt ausgesetzt worden ist, dazu bestimmt, in einer der gewünschten festgelegten Dünnung entsprechenden Tiefe eine Mikrokavitätenschicht zu erzeugen, um eine für die Spaltung in einem späteren Wärmebehandlungsschritt vorgesehene Ebene zu realisieren.

11. Verfahren nach Anspruch 10, **dadurch gekennzeichnet, dass** die Ionenimplantation durch Wasserstoffionen realisiert wird.

12. Verfahren nach einem der Ansprüche 10 oder 11 im Anschluss an Anspruch 7, **dadurch gekennzeichnet, dass** wenigstens ein Wärmebehandlungsschritt vorgesehen ist, der simultan ermöglicht, die Bildung des Kristalldefekte-Gitters und/oder des Spannungen-Gitters zu komplettieren und die Spaltungsebene zu erzeugen.

13. Verfahren nach einem der Ansprüche 1 bis 12, **dadurch gekennzeichnet, dass** der Selektivbehandlungsschritt darin besteht, die Kristallfehler (6) und/oder das Spannungen-Gitter leitfähig zu machen, so dass die genannte kristalline Zone (8) elektrisch miteinander verbundene kristalline Elemente bildet.

14. Verfahren nach Anspruch 13, **dadurch gekennzeichnet, dass** die Kristallfehler (6) durch Phosphordiffusion leitfähig gemacht werden.

15. Verfahren nach einem der Ansprüche 1 bis 12, **dadurch gekennzeichnet, dass** der Selektivbehandlungsschritt in einer elektrischen Isolierung (11) besteht, damit die genannte kristalline Zone elektrisch voneinander isolierte kristalline Elemente (9) bildet.

16. Verfahren nach Anspruch 15, **dadurch gekennzeichnet, dass** die Selektivbehandlung aus einem chemischen Ätzen der Kristallfehler und/oder des Spannungen-Gitters besteht.

17. Verfahren nach Anspruch 16, **dadurch gekennzeichnet, dass** dem genannten chemische Ätzen eine Phase der Dekoration der Kristallfehler und/oder des Spannungen-Gitters durch Fällung von metallischen Verunreinigungen oder Dotierstoffen vorausgeht.

18. Verfahren nach Anspruch 16, **dadurch gekennzeichnet, dass** dem genannten chemische Ätzen ein Abscheiden eines elektrischen Isolierstoffes folgt.

19. Verfahren nach Anspruch 15, **dadurch gekennzeichnet, dass** die genannte elektrische Isolierung von der Art ist, wo eine elektrische Leitung durch einen physikalischen Effekt stattfinden kann, zum Beispiel den Tunneleffekt oder den Fowler-Nordheim-Effekt.

20. Verfahren nach einem der Ansprüche 1 bis 12, **dadurch gekennzeichnet, dass** der Selektivbehandlungsschritt darin besteht, die Kristallfehler und/oder das Spannungen-Gitter so zu behandeln, dass die kristalline Zone kristalline Elemente ausbildet, die durch Zonen miteinander verbunden sind, die halbleitend sind oder eine Potentialbarriere bilden.

21. Verfahren nach einem der Ansprüche 1 bis 12, **dadurch gekennzeichnet, dass** der Selektivbehandlungsschritt darin besteht, durch Epitaxie ein kristallines Material abzuscheiden, das bezüglich Kristallmasche nicht übereinstimmt mit dem durch die Dünnung freigelegten kristallinen Material, wobei dieses abgeschiedene kristalline Material eine geordnete, mit dem darunterliegenden Kristalldefekte-Gitter und/oder Spannungen-Gitter übereinstimmende Gesamtheit von Inseln bildet.

22. Mikro- oder Nanostruktur auf einem Träger, **dadurch gekennzeichnet, dass** sie nach einem der Ansprüche 1 bis 21 realisiert wird, ausgehend von Plättchen (1, 2), von denen eines gedünnt worden ist, wobei diese Plättchen in Kontakt befindliche Flächen (3, 4) aus Halbleitermaterial haben, die durch die genannten Flächen präsentierten Kristallgitter wenigstens einen Diskrepanzparameter aufweisen und das gedünnte Plättchen an der Oberfläche ein Kristalldefekte-Gitter und/oder ein Spannungen-Gitter aufweist, woraus die genannte Mikro- oder Nanostuktur resultiert.

23. Mikro- oder Nanostruktur auf einem Träger nach Anspruch 22, **dadurch gekennzeichnet, dass** wenigstens eine der genannten in Kontakt zu bringenden Flächen aus SiC ist.

24. Mikro- oder Nanostruktur auf einem Träger nach Anspruch 21, **dadurch gekennzeichnet, dass** wenigstens eine der genannten in Kontakt zu bringenden Flächen aus III-V-Halbleitermaterial wie AsGa oder GaAlAs ist.

25. Mikro- oder Nanostruktur auf einem Träger, **dadurch gekennzeichnet, dass** sie nach einem der Ansprüche 1 bis 21 realisiert wird, wobei eines der Plättchen durch ein SOI-Plättchen gebildet wird und das andere Plättchen aus Silicium ist und das gedünnte Plättchen bildet, wobei das Verfahren ermöglicht, eine durch Sificium-Mikrovolumen auf einer Isolierschicht gebildete Mikro- oder Nanostruktur herzustellen.
